# EUROPEAN PATENT SPECIFICATION

(11) **EP 0 295 381 B1**
(45) Date of publication and mention of the grant of the patent: **20.08.1997**
(21) Application number: 88105900.0
(22) Date of filing: 13.04.1988
(51) Int. Cl.: C08G 73/06, G02F 1/133

(54) **Polymer having dihydrotriazine rings, process for producing the same, and applications thereof**
Polymere mit Dihydrotriazinringen, Verfahren zu ihrer Herstellung und ihre Verwendungen
Polymères ayant des cycles dihydrotriaziniques, leur procédé de fabrication et leurs applications

(30) Priority: 15.04.1987 JP 90755/87; 02.09.1987 JP 217851/87
(43) Date of publication of application: 21.12.1988
(73) Proprietor: HITACHI, LTD., Chiyoda-ku, Tokyo 100 (JP)
(72) Inventor: Nishikawa, Akio, Hitachi-shi (JP); Koyama, Tohru, Hitachi-shi (JP); Asano, Hideki, Mito-shi (JP); Narahara, Toshikazu, Naka-gun Ibaraki-ken (JP)
(74) Representative: Strehl Schübel-Hopf Groening & Partner

(56) References cited:
- US-A- 4 178 430

## Description

### FIELD OF THE INVENTION AND RELATED ART

### FIELD OF THE INVENTION

The present invention relates to a Schiff's compound which has one or two terminal cyanato groups in the molecule and on heating, forms a polymer excellent in heat resistance. The invention also relates to a polymer having dihydrotriazine rings which is produced from said Schiff's compound and further to a process for producing said polymer and to applications of the polymer.

### PRIOR ART

In the field of electronic components and the field of electrical machines and devices, there are movements to higher densities, higher reliability, and moreover smaller sizes, lighter weights, and higher performance. In order to achieve this, there is a growing need for organic materials which are convertible into hardened products having outstanding heat resistance and small coefficients of thermal expansion and are distinguished in moldability and processability (curable at low temperatures and exhibiting high flow). Heretofore, materials based on N-substituted maleimides have been investigated to meet these needs.

However, materials based on N-substituted maleimides involve a number of problems to solve such that the curing temperatures of these materials are as high as at least 200°C, adhesive properties thereof to inorganic materials and to metals are inferior, solubilities thereof in solvents are low, extensibilities or dispersibilities thereof in coating materials and the like are limited, and they are inferior in heat resistance to condensate type imides. Thus, the development of N-substituted maleimide materials is not necessarily advanced to satisfaction. On the other hand, there have been investigated in recent years applications of materials. based on imides having terminal ethynyl groups to laminates and adhesives. But, there are also problems in flow properties of these materials at the time of shaping or curing.

U.S. Patent No. 4,178,430 also describes a Schiff's compound terminated by ethynyl groups. This compound has aromatic rings and on heating forms a polymer having repeating acetylene-acetylene or en-in bonds in the molecular chain. According to this patent, this polymer is suited as a conductor or semiconductor. Furthermore, a mixture of the present polymer with silver powder can be used as a good conducter. Therefore it is doubtful to apply this polymer in the area of electronic components and electrical machinery where insulation resistance is required for the material to use. This polymer is produced through the following reactions :

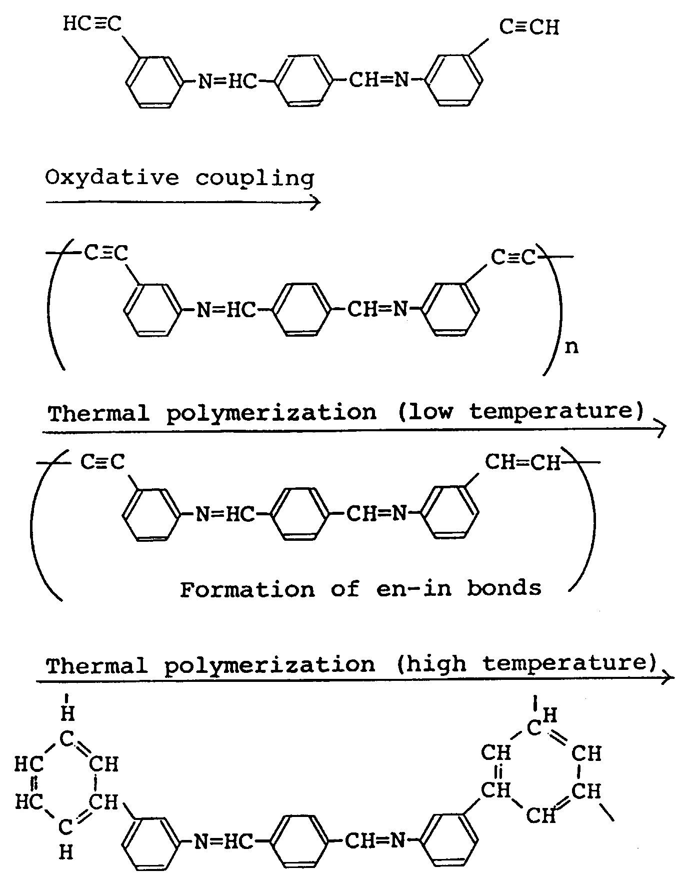

A disadvantage of the above prior art materials is that it is difficult to balance necessary properties such as heat resistance, moldability and processability, electrical-insulating properties for applications to electronic components or electrical machinery.

In particular, N-substituted maleimide-based polymers, which have been leading materials of the addition polymer type, have a drawback in that, when an attempt is made to balance the above-mentioned properties of these polymers, some deterioration of the heat resistance must be always accepted and hence it is not necessarily possible to achieve sufficiently the original object of further improving end products in performance and in reliability by applying these modified polymers.

### OBJECTS AND SUMMARY OF THE INVENTION

The primary object of the invention is to provide a novel addition polymer type of material which can solve the above noted problems.

The above and other objects of the invention can be achieved by embodying the following aspects of the invention.

The first aspect of the invention is a polymer which has dihydrotriazine rings in particular, which is produced by heating a compound having a cyanato group at each end of the molecule and plural Schiff's bonds in the molecule, said compound being represented by the general formula

N≡C-O-Y₁-N=HC-X₁-CH=N-Y₂-O-C≡N [I]

wherein X₁ is 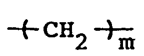 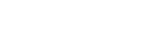 (m is an integer of 1 to 12), 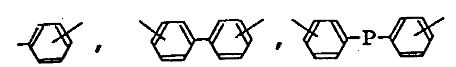 [P denotes 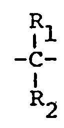 (R₁ and R₂ are the same or different and denote each -H, -CH₃, -C₂H₅, -CF₃, 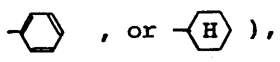 -O-, -CO-, -S-, or -SO₂-], 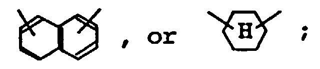 and Y₁ and Y₂ are the same or different divalent organic residues.

The second aspect of the invention is a polymer which has dihydrotriazine rings in particular, which is produced by heating a compound having a cyanato group at each end of the molecule and plural Schiff's bonds in the molecule, said compound being represented by the general formula

N≡C-O-Y₁-CH=N-X₂-N=CH-Y₂-O-C≡N [II]

wherein X₂ is 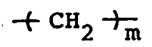 (m is an integer of 1 to 12), 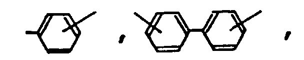 substituted-phenylene, 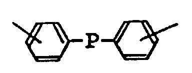 [P denotes 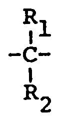 (R₁ and R₂ are the same or different and denote each -H, -CH₃, -C₂H₅, -CF₃, 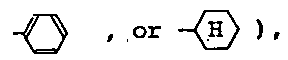 -O-, -CO-, -S-, or -SO₂-], 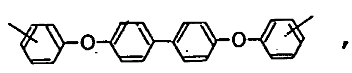 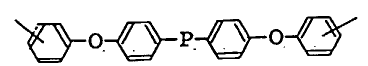 (P is as defined above), 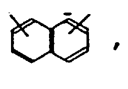 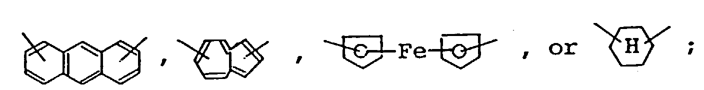 and Y₁ and Y₂ are the same or different divalent organic residues.

The third aspect of the invention is a polymer which has dihydrotriazine rings in particular, which is produced by heating a Schiff's compound(s) having a cyanato group at one end of the molecule, said compound(s) being represented by the general formula

X₃-CH=N-Y₃-O-C≡N [III]

and/or by the general formula

X₃-N=CH-Y₃-O-C≡N [IV]

wherein X₃ is -H, C₁-C₈ alkyl, 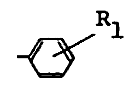 (R₁ denotes -H, -F, -Cℓ, -Br, -CH₃, -OH, -NH₂, 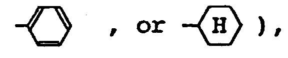 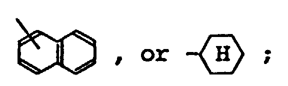 and Y₃ is 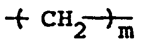 (m is an integer of 1 to 12), 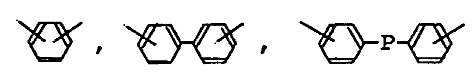 [P denotes 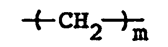 (m is as defined above), -O-, -CO-, -S-, -SO₂-, 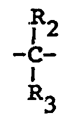 (R₂ and R₃ are the same or different and denote each -H, -CH₃, -C₂H₅, -CF₃,

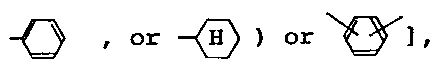

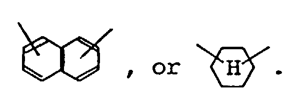

The fourth aspect of the invention is a compound useful as the raw material of the first aspect polymer, that is, the compound represented by the above general formula [I], having a cyanato group at each end of the molecule and plural Schiff's bonds in the molecule.

The fifth aspect of the invention is a compound useful as the raw material of the second aspect polymer, that is, the compound represented by the above general formula [II], having a cyanato group at each end of the molecule and plural Schiff's bonds in the molecule.

The sixth aspect of the invention is a compound useful as the raw material of the third aspect polymer, that is, the compound represented by the above general formula [III] or [IV], having a cyanato group at one end of the molecule and plural Schiff's bonds in the molecule.

The seventh aspect of the invention is a process for producing a polymer having dihydrotriazine rings defined above, the process comprising reaction by heating a compound represented by the general formula [I] to [IV].

The eighth aspect of the invention is a molecular orientation controlling coat for a liquid crystal display device, said coat being an organic film formed on a transparent electroconductive film, wherein said organic film comprises a polymer which is constituted mainly of 1,2-dihydro -1,3,5-triazine rings defined above.

The ninth aspect of the invention is a resin-sealed type of semiconductor device produced by covering at least the surface of the semiconductor component with a hardened resin, wherein the hardened resin is all or partly made up of a polymer which is constituted mainly of 1,2-dihydro-1,3,5-triazine rings defined above.

### BRIEF DESCRIPTION OF THE DRAWINGS

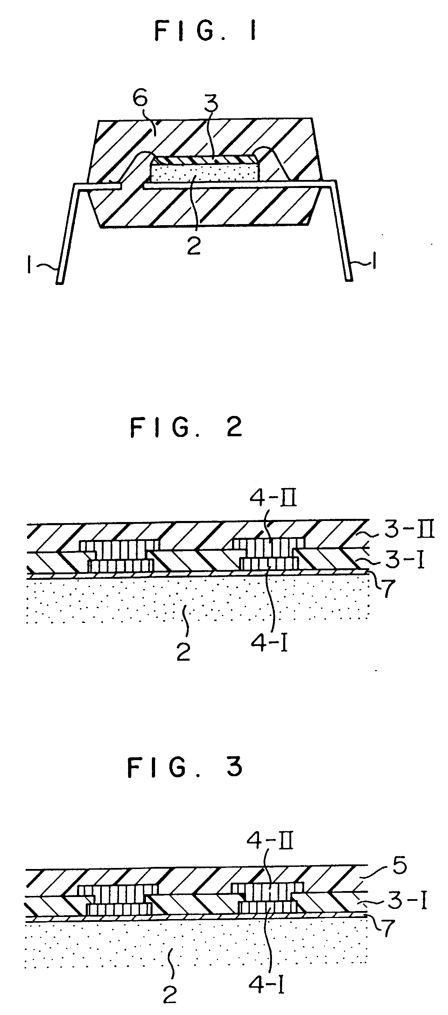

Fig. 1 is a cross-sectional view of a semiconductor device prepared in an example of the present invention. Figs. 2 and 3 are cross-sectional views of body portions of semiconductor devices pertaining to the invention.

In Figs. 1 to 3;
1...Lead wire, 2...Semiconductor, 3...Protective coating resin, 3-I...First protective coating resin, 3-II... Second protective coating resin, 4-I...First layer wiring, 4-II...Second layer wiring, 5...Polyimide resin, 6...Molded resin, 7...Thermally oxidized film

### DETAILED DESCRIPTION OF PREFERRED EMBODIMENTS

The present inventive compounds having Schiff's bonds are synthesized generally in the following ways, though not limited thereto, of course.

Compounds represented by the general formula [I]

N≡C-O-Y₁-N=HC-X₁-CH=N-Y₂-O-C≡N [I]

wherein X₁ is 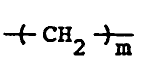 (m is an integer of 1 to 12), 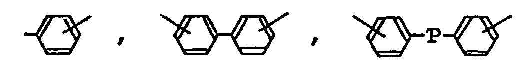 [P denotes 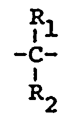 (R₁ and R₂ are the same or different and denote each -H, -CH₃, -C₂H₅, -CF₃, 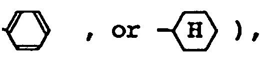 -O-, -CO-, -S-, or -SO₂-], 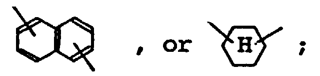 and Y₁ and Y₂ are the same or different divalent organic residues; which have a cyanato group at each end of the molecule and plural Schiff's bonds in the molecule, can be synthesized, for instance, through the following reaction process:

OHC-X₁-CHO+H₂N-Y₁-OH+H₂N-Y₂-OH

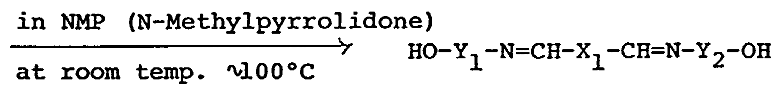

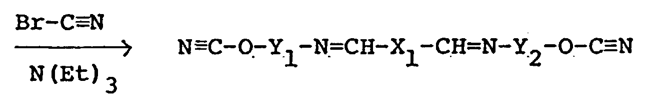

wherein, X₁, Y₁, and Y₂ are as defined above.

Compounds represented by the general formula

N≡C-O-Y₁-CH=N-X₂-N=CH-Y₂-O-C≡N [II]

wherein X₂ is 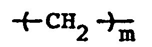 (m is an integer of 1 to 12), 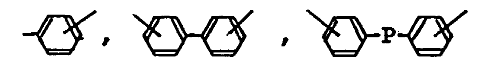 [P denotes 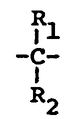 (R₁ and R₂ are the same or different and denote each -H, -CH₃, -C₂H₅, -CF₃, 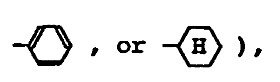 -O-, -CO-, -S-, -SO₂-, or 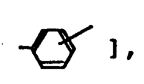 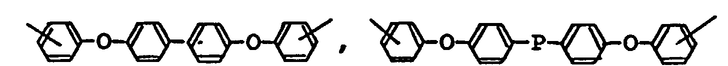 (P is as defined above), 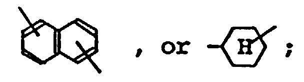 and Y₁ and Y₂ are the same or different divalent organic residues; which have a cyanato group at each end of the molecule and plural Schiff's bonds in the molecule, can be synthesized, for instance, through the following reaction process:

OHC-Y₁-OH+OHC-Y₂-OH+H₂N-X₂-NH₂

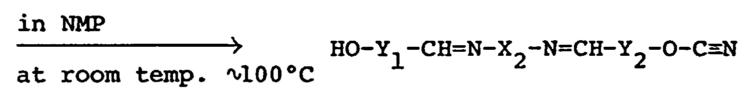

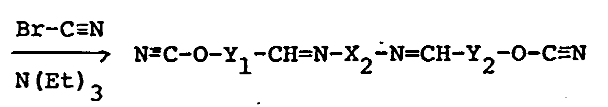

Schiff's compounds represented by the general formula

X₃-CH=N-Y₃-O-C≡N [III]

or by the general formula

X₃-N=CH-Y₃-O-C≡N [IV]

wherein X₃ is -H, C₁-C₈ alkyl, 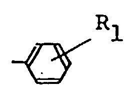 (R₁ denotes -H, -F, -Cℓ, -Br, -CH₃, -CF₃, -OH, -NH₂, 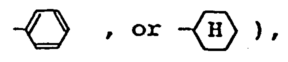 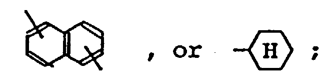 and Y₃ is 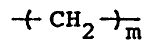 (m is an integer of 1 to 12), 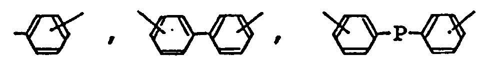 [P denotes 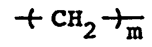 (m is as defined above), -O-, -CO-, -S-, -SO₂-, 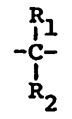 (R₁ and R₂ are the same or different and denote each -H, -CH3, -C₂H₅, -CF₃, 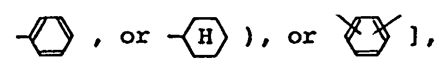 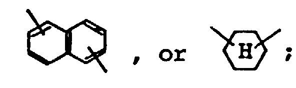 which have a cyanato group at one end of the molecule, can be synthesized by reacting the compounds, obtained by reacting monofunctional aldehyde compounds and aminophenol compounds or aliphatic aminoalcohol compounds in solvents at temperatures of ambient to 100°C as illustrated by the following reaction equations 1 to 6, with cyanogen halides (e.g., BrC≡N) in the presence of tertiary amines.

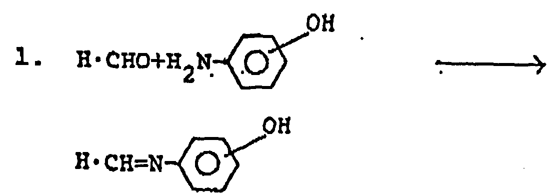

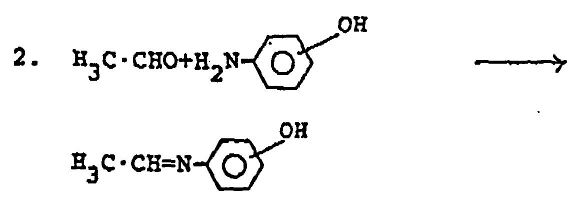

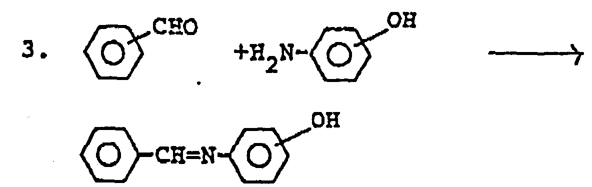

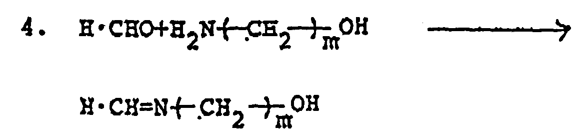

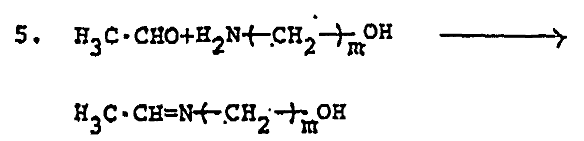

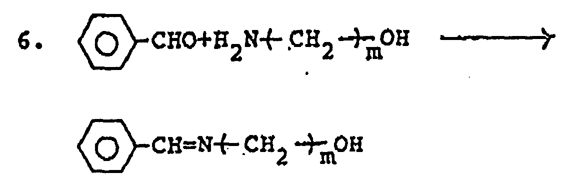

Schiff's compounds of the present invention represented by the general formula [I], [II], [III], or [IV], which have terminal cyanato groups, can be synthesized, for instance, by reacting aldehyde compounds with aminophenol compounds and then reacting the resulting Schiff's compounds having terminal cyanato groups with a cyanogen halide such as Br-C≡N or Cℓ-C≡N in the presence of a tertiary amine such as triethylamine. Another synthetic method comprises reacting a cyanogen halide with aminophenol compounds in the state of their amino groups masked, and reacting the resulting amino cyanato compounds with aldehyde compounds to form Schiff's bonds. However, there is no particular restriction in the present invention on the method for synthesizing Schiff's compounds having terminal cyanato groups. Any suitable synthetic method may be used besides the above methods.

Aldehyde compounds which are essential ingredients to synthesize the present inventive compounds of formulae [I] to [IV] include; aliphatic saturated aldehydes, e.g. formaldehyde, acetaldehyde, propionaldehyde, butyraldehyde, isobutyraldehyde, valeraldehyde, isovaleraldehyde, pivalaldehyde, caproaldehyde, heptoaldehyde; caprilaldehyde, pelargonaldehyde, capraldehyde, undecylaldehyde, lauraldehyde, dodecylaldehyde and stearaldehyde; aliphatic dialdehydes, e.g. glyoxal and succinaldehyde; ketoaldehydes, e.g. methylglyoxal, acetoacetaldehyde, levulinaldehyde, and phenylglyoxal; aliphatic unsaturated aldehydes, e.g. acrolein, crotonaldehyde, and propiolaldehyde; aromatic aldehydes, e.g. benzaldehyde, o-tolualdehyde, m-tolualdehyde, p-tolualdehyde, solicylaldehyde, cinnamaldehyde, α-naphthoaldehyde, β-naphtoaldehyde, isophthalaldehyde, terephthalaldehyde, phthalaldehyde, and 9,10-anthracenecarboxyaldehyde; aromatic dialdehydes, e.g., 9,10-anthracenedicarboxyaldehyde, 1,3-diformylazulene (produced according to a method described in Polymer Letters 2, 943 (1964); nitrogen-containing heterocyclic aldehydes, e.g. piperidine-2-aldehyde, pyridine-2-aldehyde, pyridine-3-aldehyde, pyridine-4-aldehyde, pyridine-2,6-dialdehyde, pyridine-2,4-dialdehyde, and pyridine-3,5-dialdehyde; and other known heterocyclic aldehydes including furfural, 1,1'-diformylferrocene (produced by a method discribed in Macromolecules 1, 424 (1968) or the like.

Aminophenol compounds represented by the formula H₂N-Y₁-OH or H₂N-Y₂-OH, which are essential to synthesize the present inventive compounds of formulae [I] to [IV], include, for example, o-aminophenol, m-aminophenol, p-aminophenol, also isomeric aminocresols, isomeric aminoxylenols, and a series of aliphatic aminoalcohols represented by the formula

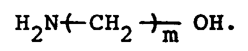

Aldehydephenol compounds represented by the formula OHC-Y₁-OH or OHC-Y₂-OH include, for example, 2-aldehydephenol, 3-aldehydephenol, 4-aldehydephenol, also isomeric aldehydecresols, isomeric aldehydexylenols, and a series of aliphatic aldehydealcohols represented by the formula

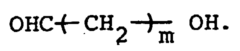

Now the seventh aspect of the present invention is described in detail.

The 7 (a)th aspect of the invention is a process for producing a polymer constituted mainly of 1,2-dihydro-1,3,5-triazine rings from a compound represented by the general formula [I]:

N≡C-O-Y₁-N=HC-X₁-CH=N-Y₂-O-C≡N [I]

wherein X₁ is 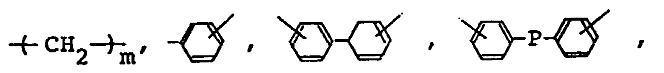 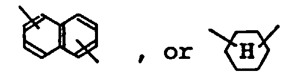 [wherein m is an integer of 1 to 12 and P is 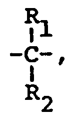 -O-, -CO-, -S-, or -SO₂- (wherein R₁ and R₂ are the same or different and denote each -H, -CH₃, -C₂H₅, 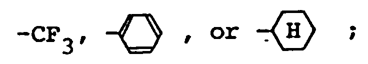 which has a cyanato group at each end of the molecule and plural Schiff's bonds in the molecule. This process comprises heating said compound at temperatures of 120 to 180°C to react it.

The 7 (b)th aspect of the invention is a process for producing a polymer constituted mainly of 1,2-dihydro-1,3,5-triazine rings from a compound represented by the general formula [II]:

N≡C-O-Y₁-CH=N-X₂-N=CH-Y₂-O-C≡N [II]

wherein X₂ is 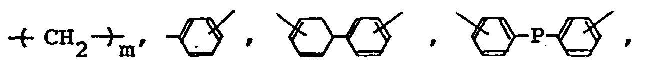 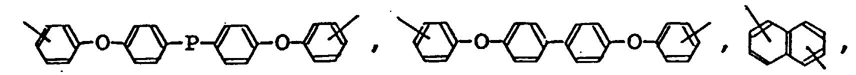 or 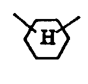 (wherein m is an integer of 1 to 12 and P is 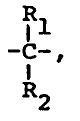 -O-, -CO-, -S-, -SO₂- (wherein R₁ and R₂ are the same or different and denote each -H, -CH₃, -C₂H₅, -CF₃, 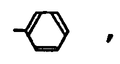 or 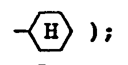 and Y₁ and Y₂ are the same or different divalent organic residues; which has a cyanato group each end of the molecule and plural Schiff's bonds in the molecule. This process comprises heating said compound at temperatures of 120 to 180°C to react it.

The 7 (c)th aspect of the invention is a process for producing a polymer constituted mainly of 1,2-dihydro-1,3,5-triazine rings from a Schiff's compound(s) represented by the general formula [III]:

X₃-CH=N-Y₃-O-C≡N [III]

and/or the general formula [IV]:

X₃-N=CH-Y₃-O-C≡N [IV]

wherein X₃ is -H, C₁-C₈ alkyl, 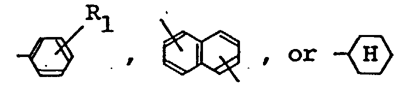 (wherein R₁ is -H, -F, -Cℓ, -Br, -CH₃, -CF₃, -OH, -NH₂, 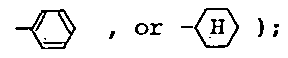 and Y₃ is 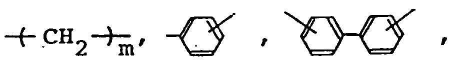 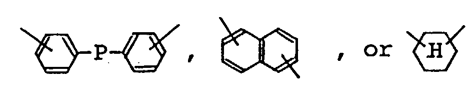 [wherein, m is an integer of 1 to 12 and P is 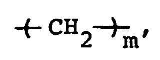 -O-, -CO-, -S-, -SO₂-, 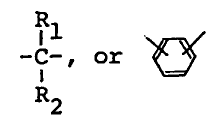 (wherein R₁ and R₂ are the same or different and denote each -H, -CH₃, -C₂H₅, -CF₃, 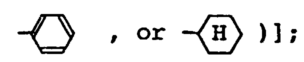 which has a cyanato group at one end of the molecule.
This process comprises heating said compound at temperatures of 120 to 180°C to react it.

The compounds of the general formulae [I] to [IV] form cross ladder structure built up of dihydrotriazine rings.

Cynato-terminated Schiff's compounds of general formulae [I] to [IV] are polymerized by applying external energy, e.g. heat or light, yielding polymers having excellent heat resistance and small coefficients of thermal expansion.

When the polymer is produced by applying thermal energy, it is desirable to control the polymerization temperature to a 10 - 30°C higher level than the melting point of the Schiff's compound used. The present inventive Schiff's compound exhibits a polymerization exothermic peak at a temperature of about 195 to about 210°C. Hence, when the polymerization is tried at temperatures of 200°C and above, a vigorous generation of heat occurs and the intended linking state cannot be obtained. Eventually, the generated thermal energy may cause polymer or monomer bonds to split and a volume of gas to evolve. Therefore, the polymerization needs to be conducted at temperatures not exceeding 180°C.

In the invention, the Schiff's compound can be polymerized with a polymerizable ethylenic compound added in such an amount as not to impair the effect of the invention, for example, in an amount of 1 to 50 parts by weight based on 100 parts by weight of the Schiff's compound. Examples of such ethylenic compounds include styrene, vinyltoluene, α-methylstyrene, divinylbenzene, diallyl phthalate, diallyl phthalate prepolymer, chlorostyrene, dichlorostyrene, bromostyrene, dibromostyrene, diallyl benzene phosphonate, diallyl arylphosphonates, diallyl arylphosphinic esters, acrylic esters, methacrylic esters, triallyl cyanurate, triallyl cyanurate prepolymer, tribromophenol allyl ether, and unsaturated polyester resins. These compounds may be used alone or in combination.

The Schiff's compound can also be used in mixtures with an N,N'-substituted bismaleimide represented by the formula 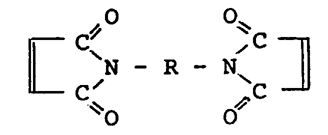 wherein R denotes alkylene, arylene, or substituted alkylene or arylene that is a divalent organic residue. Such substituted bismaleimides include, for example, N,N'-ethylenebismaleimide, N,N'-hexamethylenebismaleimide, N,N'-dodecamethylenebismaleimide, N,N'-m-phenylenebismaleimide, N,N'-4,4'-diphenyl ether bismaleimide, N,N'-4,4'-diphenylmethanebismaleimide, N,N'-4,4'-dicyclohexylmethanebismaleimide, N,N'-4,4'-m-xylenebismaleimide, and N,N'-4,4'-diphenylcyclohexanebismaleimide. Two or more of these bismaleimides can also be used in combination. Moreover, these bismaleimides may be used in suitable mixtures with mono-, di-, tri-, or tetra-substituted maleimides.

The present inventive Schiff's compounds and compositions containing these compounds are adaptable for molding compounds, laminating materials, paints or coating materials, adhesives, varnishes, ink compositions and toners, pastes, FRP compositions, liquid crystal compositions, and electroconductive materials, for various purposes, and moreover to nuclear reactor materials. In particular, they are useful for prepreg resins, interlaminar insulating films, for which demands are growing as LSI circuit layers are multiplied, coating materials for protecting LSI device surfaces, aligning films for liquid crystal devices, adhesives for aeronautical or space purposes, molding compounds, laminating materials, and silver pastes.

When the Schiff's compound is used for various purposes as mentioned above, various solvents may be used to solve it. Such solvents include polar organic solvents, e.g. N-methyl-2-pyrrolidone, N,N-dimethylacetamide; N,N-dimethylformamide, N,N-diethylformamide, N-methylformamide, dimethylsulfoxide, N,N-diethylacetamide, hexamethylphosphoramide, pyridine, dimethyl sulfone, tetramethyl sulfone, dimethyltetramethylene sulfone, and phenols, e.g. phenol, cresol, and xylenol. These solvents may be used alone or in combination. Nonsolvents such as toluene, xylene, and petroleum naphtha may also be used in small amounts jointly with solvents mentioned above.

The present inventive Schiff's compound can be converted by heating for short time at relatively low temperatures into hardened products superior in high-temperature strength, and exhibits excellent storage stability at and near room temperature and has enough fluidity for molding under low pressure. Hence, the compound exhibits wide molding and processing latitude when used for semiconductor sealants, laminating materials, and the like.

Compositions comprising the present inventive Schiff's compound can also be used jointly with one or more of the following materials according to application purposes.

That is, when said compositions are used, for instance, as molding compounds, there may be used jointly; inorganic fillers, e.g. zircon, silica, fused quartz glass, clay, hydrated alumina, calcium carbonate, quartz glass, common glass, asbestos, whiskers, gypsum, magnesite, mica, kaolin, talc, graphite, cements, carbonyl iron, barium compounds, ferrite, lead compounds, molybdenum disulfide, zinc white, titanium white, carbon black, silica sand, and wollastonite; mold-release agents, e.g. fatty acids and waxes; coupling. agents, e.g. epoxy silanes, vinylsilanes, borane compound, and alkoxy titanates; and if necessary, other known additives including flame retardants such as antimony compounds and phosphorus compounds. These additives are free to choose, of course.

In the invention, the present compound, for example, represented by any of the general formulae [I] to [IV] is applied preferably in solution form on surfaces of semiconductor devices. Suitable solvents for these purposes include; aromatic hydrocarbons, e.g. benzene and toluene; alcohols, e.g. ethanol and 2-propanol; and ketones, chlorinated hydrocarbons, and other polar solvents, e.g. N-methylpyrrolidone.

Solutions of the above compound are applied on surfaces of semiconductor components and lead wires attached thereto. Suitable methods for the application include the immersion of a semiconductor component and lead wires in said solution, the dropwise addition of said solution onto a semiconductor component and lead wires, spray coating, and spinner coating.

The semiconductor component and lead wires coated by such a method as mentioned above are then subjected to baking treatment at a temperature of at least 100°C, preferably 120 to 200°C. The compound is polymerized and crosslinked by this treatment, forming protective coating layers. For the coatings to exhibit good effects, the thickness of coatings is desired to be up to 10 µm, particularly up to 1 µm. This can be achieved by controlling the solution to a proper concentration, which is usually up to 5% by weight.

Then, as shown in Fig. 1, an epoxy composition 6 is applied to seal the semiconductor component 2 having the protective coating 3 and the lead wires 1, thus making up a resin-sealed type of semiconductor device.

The present invention is illustrated in more detail with reference to the following examples.
However, the scope of the invention is not restricted by these examples. In the examples, parts are all by weight.

### Example 1

The compound represented by the general formula [I] is applied preferably in solution form on the surface of semiconductor devices. Suitable solvents for these purposes include; aromatic hydrocarbons, e.g. benzene and toluene; alcohols, e.g. ethanol and 2-propanol; and ketones, chlorinated hydrocarbons, and other polar solvents, e.g. N-methylpyrrolidone. These solvents are preferably used in combination.

Solutions of the above compound are applied on surfaces semiconductor components and lead wires attached thereto. Suitable methods for the application include the immersion of semiconductor components and lead wires in said solution, the addition thereof dropwise onto semiconductor components and lead wires, spray coating, and spinner coating.

The semiconductor component and lead wires coated by. such a method as mentioned above are then subjected to baking treatment at a temperature of at least 100°C, preferably 120 to 200°C. The compound is polymerized and crosslinked by this treatment, forming protective coating layers. For the coating layers to exhibit good effects, the thickness thereof is desired to be up to 10 µm, particularly up to 1 µm. This can be achieved by controlling the solution to a proper concentration, which is usually up to 5% by weight.

Then, as shown in Fig. 1, the following epoxy resin composition is applied to seal the component 2 having the protective coating layer 3 and lead wires 1, thus making up a semiconductor device.

| Sealing epoxy resin composition: | |
|---|---|
| Novolac type epoxy resin | 100 parts |
| Phenol-Formaldehyde resin | 55 parts |
| Catalyst of imidazole family | 3 parts |
| Fused quartz powder | 480 parts |
| Epoxy silane | 2 parts |
| Hoechst wax | 2 parts |
| Carbon black | 1 part |

A blend having the above composition was milled for 10 minutes on a pair of rolls heated at 70-80°C, and was coarsely ground to prepare a sealing resin composition.

Semiconductors sealed with said resin composition (50 sets) were placed in an oven oversaturated with steam (a pressure cooker) whose pressure was kept 2 atmos at a temperature of 121°C for 2500 hours. Thereafter the presence of the disconnection of semiconductors was examined and no disconnected semiconductor was found.

Semiconductor components having said protective coatings can be sealed by using cans, solder-fused ceramics, or glass-fused ceramics, besides using sealing resins.

### Example 2

A 1000-mℓ, three-necked, round-bottomed flask equipped with a stirrer was charged with 300 mℓ of N-methyl-2-pyrrolidone (NMP) and 18.6 parts of p-aminophenol. Then, a solution of 13.4 parts of terephthalaldehyde in 200 mℓ of NMP was added dropwise to the mixture with stirring at room temperature. This reaction mixture was stirred at room temperature for 4 hours and further at 90-100°C for 5 hours, giving a reaction product: 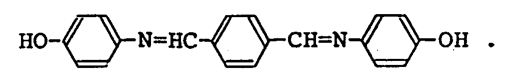 To the reaction product solution cooled were added a 10% NMP solution containing 21.2 parts of Br-C≡N and 0.8 part of triethylamine and the reaction was carried out at 70-100°C for 4 hours. Then, the resulting mixture was added to 3000 mℓ of water to form a precipitate. After 24 hours' standing, the precipitate was filtered, washed, and dried, yielding 35.8 parts of the intended product (A'):

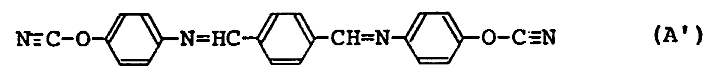

### Example 3

A 1000-mℓ, three-necked, round-bottomed flask equipped with a stirrer was charged with 300 mℓ of NMP 21.6 parts of p-aminobenzcyanate. Then, a solution of 13.4 g (0.1 mole) of isophthalaldehyde in 200 mℓ of NMP was added dropwise to the mixture with stirring at room temperature. This reaction mixture was stirred at room temperature for 4 hours and further at 90-100°C for 5 hours. Then, the resulting mixture was added to 3000 mℓ of water to form a precipitate. After 24 hours' standing, the precipitate was filtered, washed with pure water, and dried at 100-110°C for about 3 hours, yielding the intended product:

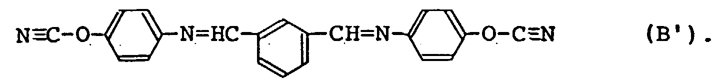

Table 7 shows the weight-loss initiation temperatures and 5% weight-loss temperatures of the cyanato-terminated Schiff's compounds (A') and (B') prepared in Examples 2 and 3, respectively, and those of an N-substituted bismaleimide (BMI) and of an ethynyl-terminated imide oligomer MC-600: 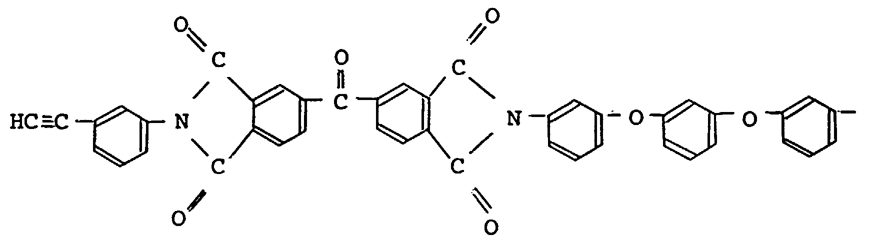 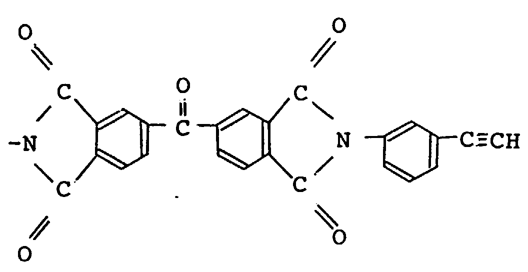 and the coefficients of thermal expansion of hardened products of these four compounds.

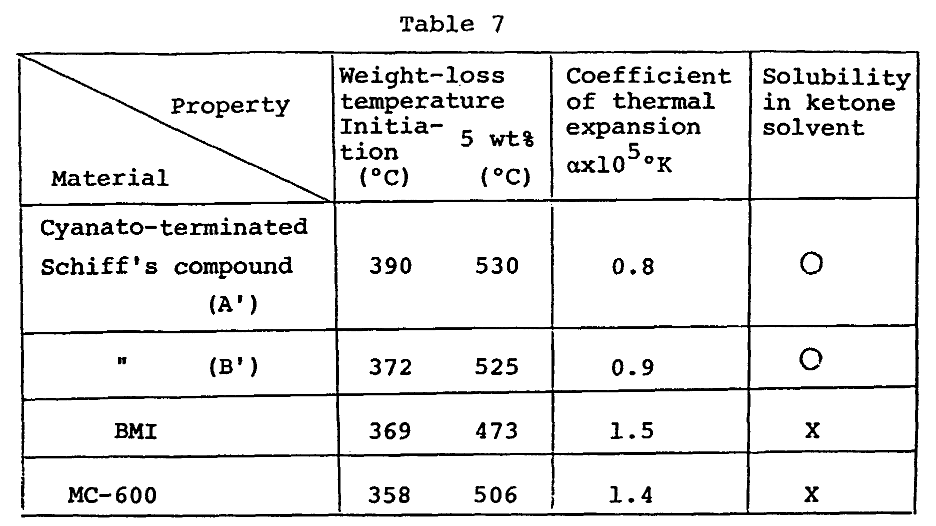

### Example 4

A cyanato-terminated Schiff's compound: 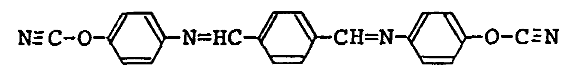 was dissolved in a 50 : 50 (by weight) NMP-MEK mixture to prepare 100 mℓ of a varnish of 8 wt% concentration. Then, a glass fabric (WF-230, mfd. by Nitto-bo Co., Ltd.) was immersed in the varnish, and the impregnated fabric was dried by heating at 100-120°C for about 3 hours. The resin content of the obtained prepreg was 4 wt%.

Then, 6 sheets of the prepreg were superposed together and compression-molded under the conditions of 160°C x 50 Kg·f/cm² x 2 hours. The molding showed a tensile strength of 16.5 Kg/cm² at 100°C (ASTM D-638), flexural strength of 15.5 Kg/cm² at 100°C (ASTM D-790), and Izod impact strength (notched) of 6.6 Kg·cm/cm at 25°C (ASTM D-256).

### Example 5

A cyanato-terminated Schiff's compound: 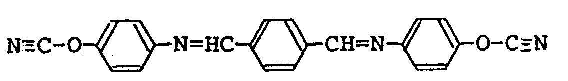 was dissolved in dimethylformamide to prepare a solution of 2 wt% concentration. Then, this solution was applied by using a spinner coater at 3500 rpm on a thoroughly-washed transparent conductive film supported by a polyethylene terephthalate film, and was dried at 120°C for 15 minutes to evaporate the dimethylformamide and form a 650-Å thick film, which was rubbed with felt in a definite direction, thus preparing the above prepared structure having a molecular orientation controlling film.

Two films prepared in this way were arranged with the orientation controlling films facing each other, and was bonded together by using a polyester-based sealant, forming a liquid crystal display device. A liquid crystal of the phenylcyclohexane family (ZLI-1132, mfd. by Merck Co.) was filled in the space between the orientation controlling films, and the orientation state of the liquid crystal was examined by inserting the device between two crossed polarizing plates, where the liquid crystal showed a good orientation state.

### Example 6

Compound (A') prepared in Example 2 was dissolved in toluene to prepare a solution of 1 wt% concentration. Figs. 2 and 3 show each the structure of a semiconductor device provided with double-layer circuit insulating films formed by using this solution.

The device was constructed as follows: An Si substrate was overlaid in turn with an insulating SiO₂ layer and with a poly silicon layer, and a first aluminum wiring (4-I) was formed thereon. A portion of the above solution was applied (using a spinner coater) on the wiring, and dried and baked (250°C for 60 minutes) to form a first insulating film (3-I). Then, a positive resist composition, and the aluminum foil was patterned. Thereafter, plasma etching was conducted by using CF₄-O₂ as reactant gas and further using O₂ as reactant gas, thereby removing the positive resist.

In the next place, a second aluminum wiring (4-II) was formed, and a portion of the above solution was further applied, and baked (under the same conditions as mentioned above) to form a second insulating film (3-II).

Fig. 2 shows the structure of a semiconductor device (5 layers) wherein the second insulating film was formed from a polyimide resin (PIQ, mfd. by Hitachi Kasei Co., Ltd.).

The semiconductor device thus prepared according to the present invention was packaged by using an epoxy resin molding compound with a phenol novolac hardener, thereby preparing an LSI for memory use (1M bit D-RAM memory). After this LSI had been allowed to stand in an atmosphere of 85°C and 85% R. H. for 3000 hours while applying a bias, no wire break failure due to Aℓ wire corrosion occurred therein. Thus, the LSI was found to be excellent in moisture resistance. The soft error ratio of this LSI is 50 Fit 10⁻⁹/number of LSI x hours and it is superior in α-ray resistance.

An epoxy resin blend having the following composition was milled for 10 minutes on a pair of rolls heated at 70-80°C, and was coarsely ground to prepare a sealing resin composition.

| Sealing epoxy resin composition: | |
|---|---|
| Novolac type epoxy resin | 100 parts |
| Phenol-Formaldehyde resin | 55 parts |
| Catalyst of imidazole family | 3 parts |
| Fused quartz powder | 480 parts |
| Epoxy silane | 2 parts |
| Hoechst wax | 2 parts |
| Carbon black | 1 part |

Semiconductor components having said protective coatings can-be sealed by using cans, solder-fused ceramics, or glass-fused ceramics, besides by using resins.

The polymer produced from the Schiff's compound of the present invention is characterized by being superior in solubilities in general-purpose solvents to conventional addition polymers and providing hardened products which are equal or superior in heat resistance to those of the conventionals and exhibit smaller coefficients of thermal expansion.

## Claims

1. A polymer having a cross ladder-like molecular skeleton which comprises dihydrotriazine rings from a Schiff's compound having a cyanato group at each end of the molecule and plural Schiff's bonds in the molecule, said compound- being represented by the general formula
N≡C-O-Y₁-N=HC-X₁-CH=N-Y₂-O-C≡N [I]
wherein X₁ is 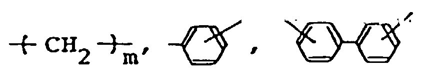 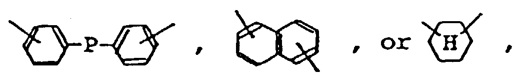 wherein m is an integer of 1 to 12 and P is 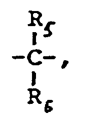 -O-, -CO-, -S-, or -SO₂-, wherein R₅ and R₆ are the same or different and denote each -H, -CH₃, -C₂H₅, -CF₃, 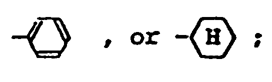 and Y₁ and Y₂ are the same or different divalent organic residues, which is produced by polymerizing said Schiff's compound under heating.at temperatures between 120°C and 180°C.

2. A polymer having a cross ladder-like molecular skeleton which comprises dihydrotriazine rings from a Schiff's compound having a cyanato group at each end *of* the molecule and plural Schiff's bonds in the molecule, said compound being represented by the general formula
N≡C-O-Y₁-CH=N-X₂-N=CH-Y₂-O-C≡N [II]
wherein X₂ is 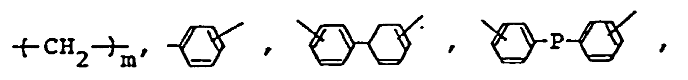 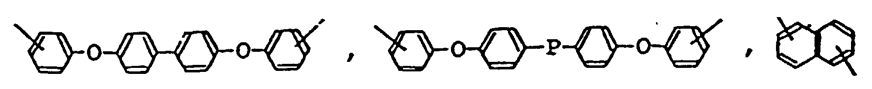 substituted phenylene, 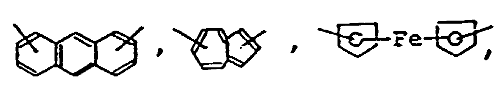 or 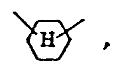 wherein m is an integer of 1 to 12 and P is 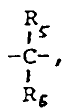 -O-, -CO-, -S-, or -SO₂-, wherein R₅ and R₆ are the same or different and denote each -H, -CH₃, -C₂H₅, -CF₃, 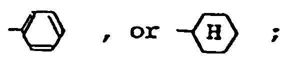 and Y₁ and Y₂ are the same or different divalent organic residues, which is produced by polymerizing said Schiff's compound under heating at temperatures between 120° and 180°C.

3. A polymer having a cross ladder-like molecular skeleton which comprises dihydrotriazine rings from a Schiff's compound having a cyanato group at one end of the molecule, said compound(s) being represented by the general formula
X₃-CH=N-Y₃-O-C≡N [III]
and/or by the general formula
X₃-N=CH-Y₃-O-C≡N [IV]
wherein X₃ is -H, C₁-C₈ alkyl, 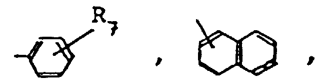 or 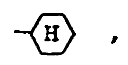 wherein R₇ is -H, -F, -Cℓ, -Br, -CH₃, -CF₃, -OH, -NH₂, 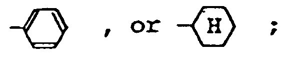 and Y₃ is 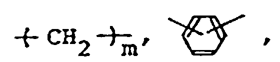 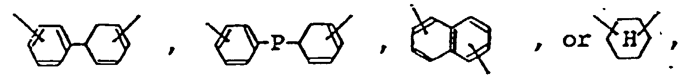 wherein m is an integer of 1 to 12 and P is 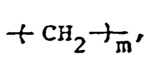 -O-, -CO-, -S-, -SO₂-, 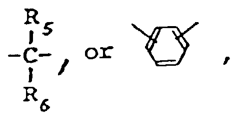 wherein R₅ and R₆ are the same or different and denote each -H, -CH₃, -C₂H₅, -CF₃, 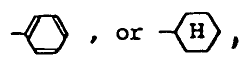 which is produced by polymerizing said Schiff's compound under heating at temperatures between 120° and 180°C.

4. A process for producing a polymer exhibiting a cross ladder-like molecular skeleton having dihydrotriazine rings, which comprises heating a Schiff's compound of the general formula (I), (II), (III), (IV), or a mixture of compounds of the general formulae (III) and (IV) as defined in claims 1 to 3 at temperatures between 120°C and 180°C to polymerise the compound through the addition of two cyanato groups to one Schiff's bond.

5. A Schiff's compound which has a cyanato group at each end of the molecule and plural Schiff's bonds in the molecule and is represented by the general formula
N=C-O-Y₁-CH=N-X₁-N=CH-Y₂-O-C≡N [I]
wherein X₁ is 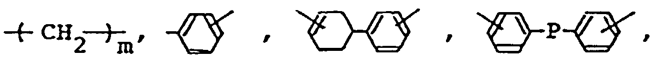 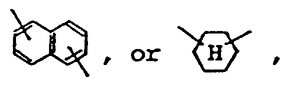 wherein m is an integer of 1 to 12 and P is 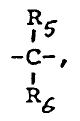 -O-, -CO-, -S-, or -SO₂-, wherein R₅ and R₆ are the same or different and denote each -H, -CH₃, -C₂H₅, -CF₃, 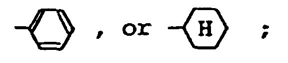 and
Y₁ and Y₂ are the same or different divalent organic residues.

6. A Schiff's compound which has a cyanato group at each end of the molecule and plural Schiff's bonds in the molecule and is represented by the general formula
N≡C-O-Y₁-CH=N-X₂-N=CH-Y₂-O-C≡N [II]
wherein X₂ is 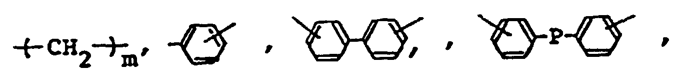 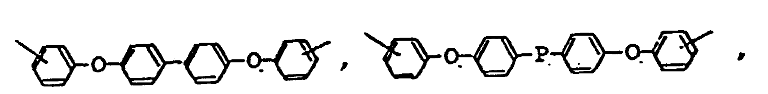 substituted phenylene, 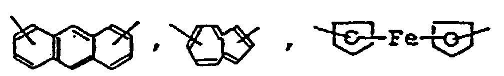 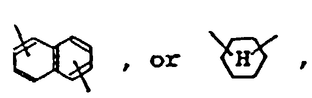 wherein m is an integer of 1 to 12 and P is 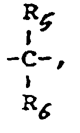 -O-, -CO-, -S-, or -SO₂-,
wherein R₅ and R₆ are the same or different and denote each -H, -CH₃, -C₂H₅, -CF₃, 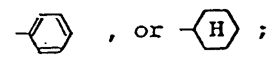 and
Y₁ and Y₂ are the same or different divalent organic residues.

7. A Schiff's compound which has an cyanato group at one end of the molecule and is represented by the general formula
X₃-CH=N-Y₃-O-C≡N [III]
and/or by the general formula
X₃-N-CH-Y₃-O-C≡N [IV]
wherein X₃ is -H, C₁-C₈ alkyl, 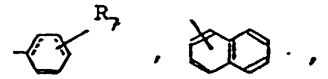 or 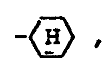 wherein R₇ is -H, -F, -Cℓ, -Br, -CH₃, -CF₃, -OH, -NH₂, 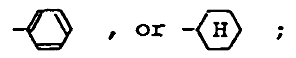 and Y₃ is 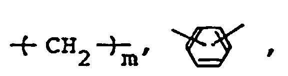 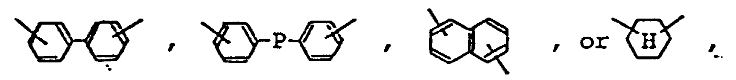 wherein m is an integer of 1 to 12 and P is 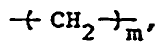 -O-, -CO-, -S-, -SO₂-, 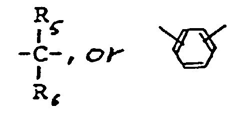 wherein R₅ and R₆ are the same or different and denote each -H, -CH₃, -C₂H₅, -CF₃,

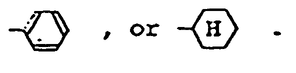

8. A molecular orientation controlling coating for a liquid crystal display device, said coating being an organic film formed on a transparent electro-conductive film, wherein said organic film is formed of a polymer according to any of the claims 1 to 3.

9. A resin-sealed type of semiconductor device produced by covering at least the surface of the semiconductor component with a hardened resin, wherein the hardened resin consisting of repeating units which are constituted mainly of dihydrotriazine rings as specified in any of the claims 1 to 3.

10. Use of the Schiff's compounds as defined in claims 1 to 3 or compositions containing these compounds as moulding compounds.

11. Use of the Schiff's compounds as defined in claims 1 to 3 or compositions containing these compounds as laminating materials.

12. Use of the Schiff's compounds as defined in claims 1 to 3 or compositions containing these compounds as paints or coating materials.

13. Use of the Schiff's compounds as defined in claims 1 to 3 or compositions containing these compounds as adhesives.

14. Use of the Schiff's compounds as defined in claims 1 to 3 or compositions containing these compounds as varnishes.

15. Use of the Schiff's compounds as defined in claims 1 to 3 or compositions containing these compounds as ink compositions and toners.

16. Use of the Schiff's compounds as defined in claims 1 to 3 or compositions containing these compounds as pastes.

17. Use of the Schiff's compounds as defined in claims 1 to 3 or compositions containing these compounds as FRP compositions.

18. Use of the Schiff's compounds as defined in claims 1 to 3 or compositions containing these compounds as liquid crystal compositions.

19. Use of the Schiff's compounds as defined in claims 1 to 3 or compositions containing these compounds as electroconductive materials.

20. Use of the Schiff's compounds as defined in claims 1 to 3 or compositions containing these compounds as nuclear reactor materials.

21. Use of the Schiff's compounds as defined in claims 1 to 3 or compositions containing these compounds for prepreg resins.

22. Use of the Schiff's compounds as defined in claims 1 to 3 or compositions containing these compounds as interlaminar insulating films.

23. Use of the Schiff's compounds as defined in claims 1 to 3 or compositions containing these compounds as coating materials for protecting LSI device surfaces.

24. Use of the Schiff's compounds as defined in claims 1 to 3 or compositions containing these compounds as aligning films for liquid crystal devices.

25. Use of the Schiff's compounds as defined in claims 1 to 3 or compositions containing these compounds as adhesives for aeronautical or space purposes.

26. Use of the Schiff's compounds as defined in claims 1 to 3 or compositions containing these compounds as silver pastes.

## Patentansprüche

1. Polymer mit einem sprossenleiterförmigen Molekülskelett, das Dihydrotriazinringe von einer Schiffschen Verbindung mit einer Cyanatgruppe an jedem Ende des Moleküls und mehreren Schiffschen Bindungen in dem Molekül enthält, wobei die Verbindung durch folgende allgemeine Formel dargestellt ist:
N≡C-O-Y₁-N=HC-X₁-CH=N-Y₂-O-C≡N [I]
wobei X₁ 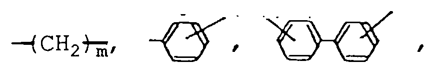 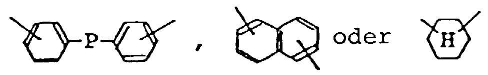 ist, wobei m eine ganze Zahl von 1 bis 12 und 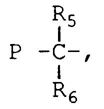 -O-, -CO-, -S-, oder -SO₂- ist, wobei R₅ und R₆ gleich oder verschieden sind und jeweils -H, -CH₃, -C₂H₅, -CF₃, 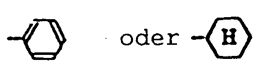 darstellen, und
Y₁ und Y₂ gleiche oder verschiedene zweiwertige organische Reste sind,
das durch Polymerisieren der Schiffschen Verbindung unter Erwärmen auf Temperaturen zwischen 120° und 180°C hergestellt wird.

2. Polymer mit einem sprossenleiterförmigen Molekülskelett, das Dihydrotriazinringe von einer Schiffschen Verbindung mit einer Cyanatgruppe an jedem Ende des Moleküls und mehreren Schiffschen Bindungen in dem Molekül enthält, wobei die Verbindung durch die folgende allgemeine Formel dargestellt ist:
N≡C-O-Y₁-CH=N-X₂-N=CH-Y₂-O-C≡N [II]
wobei X₂ 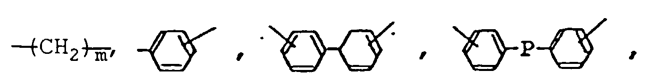 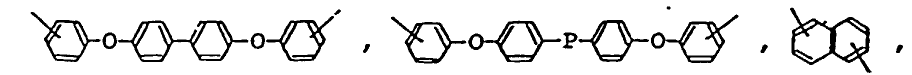 substituiertes Phenylen, 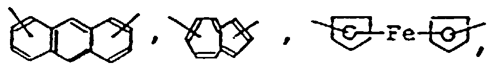 oder 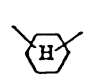 ist, wobei m eine ganze Zahl von 1 bis 12 und 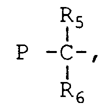 -O-, -CO-, -S- oder -SO₂- ist, wobei R₅ und R₆ gleich oder verschieden sind und jeweils -H, -CH₃, -C₂H₅, -CF₃, 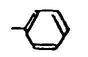 oder 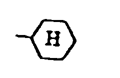 darstellen, und Y₁ und Y₂ gleiche oder verschiedene zweiwertige organische Reste sind,
das durch Polymerisieren der Schiffschen Verbindung unter Erhitzen bei Temperaturen zwischen 120 und 180°C hergestellt wird.

3. Polymer mit einem sprossenleiterförmigen Molekülskelett, das Dihydrotriazinringe von einer Schiffschen Verbindung mit einer Cyanatgruppe an einem Ende des Moleküls enthält, wobei die Verbindung durch die allgemeine Formel
X₃-CH=N-Y₃-O-C≡N [III]
und/oder durch die allgemeine Formel
X₃-N=CH-Y₃-O-C≡N [IV]
dargestellt ist, wobei X₃ -H, C₁-C₈-Alkyl, 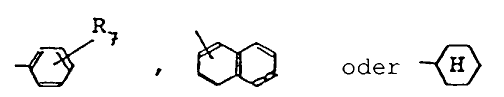 ist, wobei R₇ -H, -F, -Cℓ, -Br, -CH₃, -CF₃, -OH, -NH₂, 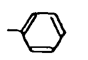 oder 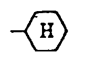 ist, und Y₃ 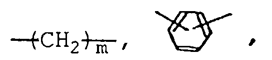 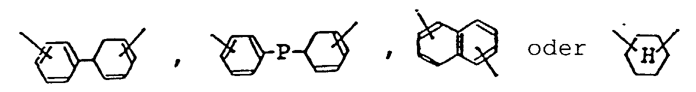 ist, wobei m eine ganze Zahl von 1 bis 12 und P 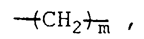 -O-, -CO-, -S-, -SO₂-, 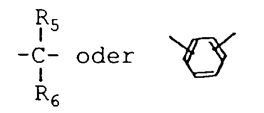 ist, wobei R₅ und R₆ gleich oder verschieden sind und jeweils -H, -CH₃, -C₂H₅, -CF₃, 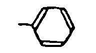 oder 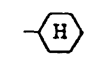 darstellen,
das durch Polymerisieren der Schiffschen Verbindung unter Erhitzen bei Temperaturen zwischen 120° und 180°C hergestellt wird.

4. Verfahren zur Herstellung eines Polymers, das ein sprossenleiterförmiges Molekülskelett mit Dihydrotriazinringen aufweist, welches das Erhitzen einer Schiffschen Verbindung der allgemeinen Formel (I), (II), (III), (IV) oder eines Gemisches der in den Ansprüchen 1 bis 3 definierten Verbindungen der allgemeinen Formeln (III) und (IV) bei Temperaturen zwischen 120°C und 180°C umfaßt, wobei die Verbindung durch die Addition von zwei Cyanatgruppen an eine Schiffsche Bindung polymerisiert wird.

5. Schiffsche Verbindung mit einer Cyanatgruppe an jedem Ende des Moleküls und mehreren Schiffschen Bindungen in dem Molekül, die durch die folgende allgemeine Formel dargestellt ist:
N≡C-O-Y₁-CH=N-X₁-N=CH-Y₂-O-C≡N [I]
wobei X₁ 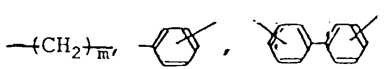 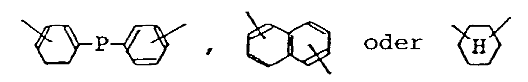 ist,
wobei m eine ganze Zahl von 1 bis 12 und 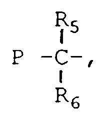 -O-, -CO-, -S-, oder -SO₂- ist, wobei R₅ und R₆ gleich oder verschieden sind und jeweils -H, -CH₃, -C₂H₅, -CF₃, 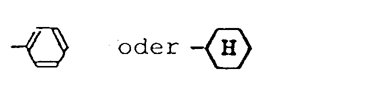 darstellen, und
Y₁ und Y₂ gleiche oder verschiedene zweiwertige organische Reste sind.

6. Schiffsche Verbindung mit einer Cyanatgruppe an jedem Ende des Moleküls und mehreren Schiffschen Bindungen in dem Molekül, die durch die folgende allgemeine Formel dargestellt ist:
N≡C-O-Y₁-CH=N-X₂-N=CH-Y₂-O-C≡N [II]
wobei X₂ 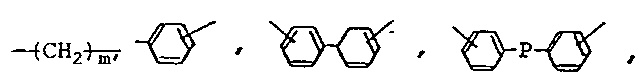 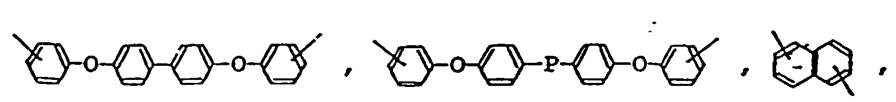 substituiertes Phenylen, 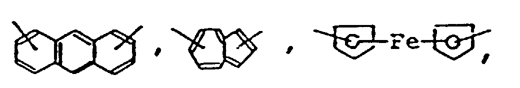 oder 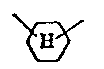 ist, wobei m eine ganze Zahl von 1 bis 12 und 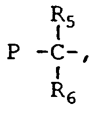 -O-, -CO-, -S- oder -SO₂- ist, wobei R₅ und R₆ gleich oder verschieden sind und jeweils -H, -CH₃, -C₂H₅, -CF₃, 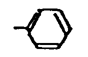 oder 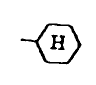 darstellen, und Y₁ und Y₂ gleiche oder verschiedene zweiwertige organische Reste sind.

7. Schiffsche Verbindung mit einer Cyanatgruppe an einem Ende des Moleküls, die durch die allgemeine Formel
X₃-CH=N-Y₃-O-C≡N [III]
und/oder durch die allgemeine Formel
X₃-N=CH-Y₃-O-C≡N [IV]
dargestellt ist,
wobei X₃ -H, C₁-C₈-Alkyl, 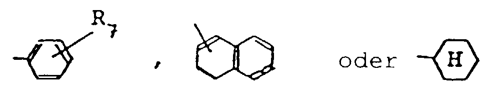 ist, wobei R₇ -H, -F, -Cℓ, -Br, -CH₃, -CF₃, -OH, -NH₂, 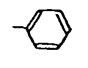 oder 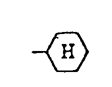 ist, und Y₃ 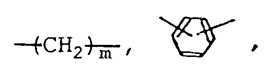 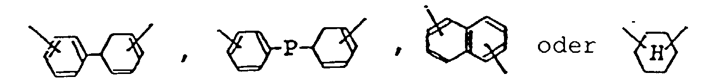 ist, wobei m eine ganze Zahl von 1 bis 12 und P 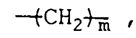 -O-, -CO-, -S-, -SO₂-, 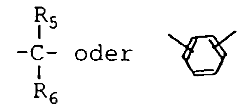 ist, wobei R₅ und R₆ gleich oder verschieden sind und jeweils -H, -CH₃, -C₂H₅, -CF₃, 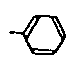 oder 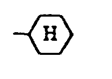 darstellen.

8. Beschichtung zum Kontrollieren der molekularen Orientierung bei Flüssigkristallanzeigevorrichtungen, wobei die Beschichtung ein organischer Film ist, der auf einem durchsichtigen elektrisch leitfähigen Film gebildet ist, wobei der organische Film aus einem Polymer gemäß einem der Ansprüche 1 bis 3 hergestellt ist.

9. Halbleitervorrichtung vom Typ einer harzversiegelten Halbleitervorrichtung, die durch Bedecken mindestens der Oberfläche der Halbleiterkomponente mit einem gehärtetem Harz hergestellt ist, wobei das gehärtete Harz aus wiederkehrenden Einheiten besteht, die hauptsächlich aus in einem der Ansprüche 1 bis 3 angegebenen Dihydrotriazinringen bestehen.

10. Verwendung der in den Ansprüchen 1 bis 3 definierten Schiffschen Verbindungen oder Zusammensetzungen, die diese Verbindungen enthalten, als Formmassen.

11. Verwendung der in den Ansprüchen 1 bis 3 definierten Schiffschen Verbindungen oder Zusammensetzungen, die diese Verbindungen enthalten, als Laminiermaterialien.

12. Verwendung der in den Ansprüchen 1 bis 3 definierten Schiffschen Verbindungen oder Zusammensetzungen, die diese Verbindungen enthalten, als Anstrichfarben oder Überzugsmassen.

13. Verwendung der in den Ansprüchen 1 bis 3 definierten Schiffschen Verbindungen oder Zusammensetzungen, die diese Verbindungen enthalten, als Klebstoffe.

14. Verwendung der in den Ansprüchen 1 bis 3 definierten Schiffschen Verbindungen oder Zusammensetzungen, die diese Verbindungen enthalten, als Lacke.

15. Verwendung der in den Ansprüchen 1 bis 3 definierten Schiffschen Verbindungen oder Zusammensetzungen, die diese Verbindungen enthalten, als Druckfarbenzusammensetzungen oder Toner.

16. Verwendung der in den Ansprüchen 1 bis 3 definierten Schiffschen Verbindungen oder Zusammensetzungen, die diese Verbindungen enthalten, als Pasten.

17. Verwendung der in den Ansprüchen 1 bis 3 definierten Schiffschen Verbindungen oder Zusammensetzungen, die diese Verbindungen enthalten, als Zusammensetzungen für glasfaserverstärkte Kunststoffe.

18. Verwendung der in den Ansprüchen 1 bis 3 definierten Schiffschen Verbindungen oder Zusammensetzungen, die diese Verbindungen enthalten, als Flüssigkristallzusammensetzungen.

19. Verwendung der in den Ansprüchen 1 bis 3 definierten Schiffschen Verbindungen oder Zusammensetzungen, die diese Verbindungen enthalten, als elektrisch leitfähige Materialien.

20. Verwendung der in den Ansprüchen 1 bis 3 definierten Schiffschen Verbindungen oder Zusammensetzungen, die diese Verbindungen enthalten, als Kernreaktormaterialien.

21. Verwendung der in den Ansprüchen 1 bis 3 definierten Schiffschen Verbindungen oder Zusammensetzungen, die diese Verbindungen enthalten, als Prepregharze.

22. Verwendung der in den Ansprüchen 1 bis 3 definierten Schiffschen Verbindungen oder Zusammensetzungen, die diese Verbindungen enthalten, als interlaminare Isolierschicht.

23. Verwendung der in den Ansprüchen 1 bis 3 definierten Schiffschen Verbindungen oder Zusammensetzungen, die diese Verbindungen enthalten, als Überzugsmasse zum Schutz der Oberflächen von LSI-Vorrichtungen.

24. Verwendung der in den Ansprüchen 1 bis 3 definierten Schiffschen Verbindungen oder Zusammensetzungen, die diese Verbindungen enthalten, als Film zum Ausrichten von Flüssigkristallvorrichtungen.

25. Verwendung der in den Ansprüchen 1 bis 3 definierten Schiffschen Verbindungen oder Zusammensetzungen, die diese Verbindungen enthalten, als Klebstoffe für die Luft- und Raumfahrt.

26. Verwendung der in den Ansprüchen 1 bis 3 definierten Schiffschen Verbindungen oder Zusammensetzungen, die diese Verbindungen enthalten, als Silberpasten.

## Revendications

1. Polymère ayant un squelette moléculaire réticulé de type échelle, qui comprend des cycles dihydrotriazines d'un composé de Schiff ayant un groupe cyanato à chaque extrémité de la molécule et plusieurs liaisons de Schiff dans la molécule, ledit composé étant représenté par la formule générale :
N≡C-O-Y₁-N=HC-X₁-CH=N-Y₂-O-C≡N (I)
dans laquelle X₁ représente -(-CH₂-)ₘ-, 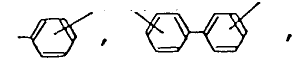 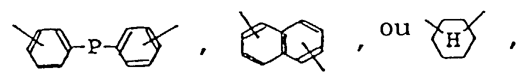 m étant un nombre entier de 1 à 12 et P représentant 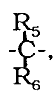 -O-,-CO-,-S- ou -SO₂-, R₅ et R₆ étant identiques ou différents et représentant chacun -H, -CH₃, -C₂H₅, -CF₃, 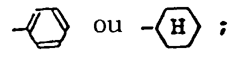 et Y₁ et Y₂ sont des restes organiques divalents identiques ou différents,
qui est obtenu par polymérisation dudit composé de Schiff par chauffage à des températures comprises entre 120°C et 180°C.

2. Polymère ayant un squelette moléculaire réticulé de type échelle, qui comprend des cycles dihydrotriazines d'un composé de Schiff ayant un groupe cyanato à chaque extrémité de la molécule et plusieurs liaisons de Schiff dans la molécule, ledit composé étant représenté par la formule générale :
N≡C-O-Y₁-HC=N-X₂-N=CH-Y₂-O-C≡N (II)
dans laquelle X₂ représente -(-CH₂-)ₘ-, 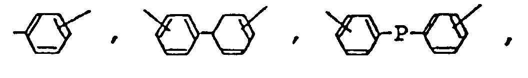 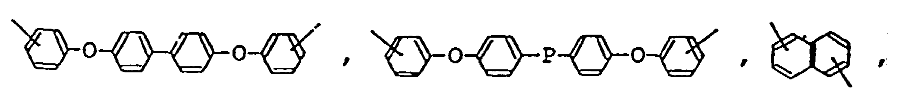 un groupe phénylène substitué, 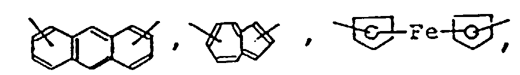 ou 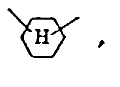 m étant un nombre entier de 1 à 12 et P représentant 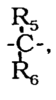 -O-,-CO-,-S- ou -SO₂-, R₅ et R₆ étant identiques ou différents et représentant chacun -H, -CH₃, -C₂H₅, -CF₃, 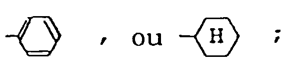 et Y₁ et Y₂ sont des restes organiques divalents identiques ou différents, qui est obtenu par polymérisation dudit composé de Schiff par chauffage à des températures comprises entre 120°C et 180°C.

3. Polymère ayant un squelette moléculaire réticulé de type échelle, qui comprend des cycles dihydrotriazines d'un composé de Schiff ayant un groupe cyanato à une extrémité de la molécule, ledit ou lesdits composé(s) étant représenté(s) par la formule générale :
X₃-CH=N-Y₃-O-C≡N (III)
et/ou par la formule générale
X₃-N=CH-Y₃-O-C≡N (IV)
X₃ représentant -H-, alkyle en C₁-C₈, 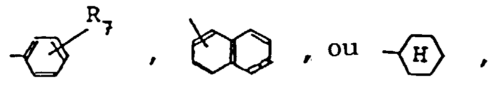 R₇ représentant -H, -F, -Cl, -Br, -CH₃, -CF₃, -OH, -NH₂, 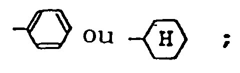 et Y₃ représente -(-CH₂-)ₘ-, 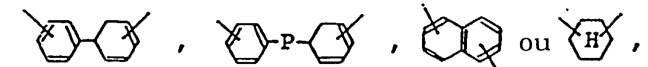 m étant un nombre entier de 1 à 12 et P représentant -(-CH₂-)ₘ-, -O-, -CO-, -S-, -SO₂-, 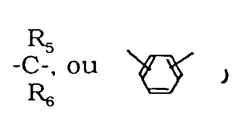 R₅ et R₆ étant identiques ou différents et représentant chacun -H, -CH₃, -C₂H₅, -CF₃, 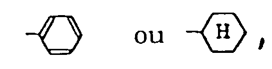 qui est obtenu par polymérisation dudit composé de Schiff par chauffage à des températures comprises entre 120°C et 180°C.

4. Procédé de préparation d'un polymère ayant un squelette moléculaire réticulé de type échelle, qui comprend des cycles dihydrotriazines, comportant les étapes consistant à chauffer un composé de Schiff de formule générale (I), (II), (III), (IV), ou un mélange de composés de formules générales (III) et (IV), tels que définis dans les revendications 1 à 3, à des températures comprises entre 120°C et 180°C, afin de polymériser le composé par addition de deux groupes cyanato sur une liaison de Schiff.

5. Composé de Schiff ayant un groupe cyanato à chaque extrémité de la molécule et plusieurs liaisons de Schiff par molécule, ledit composé étant représenté par la formule générale :
N≡C-O-Y₁-CH=N-X₁-CH=N-Y₂-O-C≡N (I)
dans laquelle X₁ représente -(-CH₂-)ₘ-, 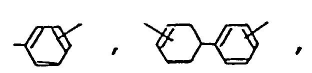 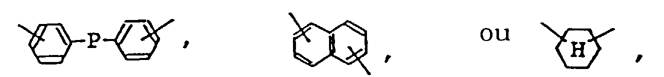 m étant un nombre entier de 1 à 12 et P représentant 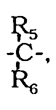 -O-, -CO-, -S- ou -SO₂-, R₅ et R₆ étant identiques ou différents et représentant chacun -H, -CH₃, -C₂H₅, -CF₃, 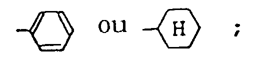 et Y₁ et Y₂ sont des restes organiques divalents identiques ou différents.

6. Composé de Schiff ayant un groupe cyanato à chaque extrémité de la molécule et plusieurs liaisons de Schiff par molécule, représenté par la formule générale :
N≡C-O-Y₁-HC=N-X₂-N=CH-Y₂-O-C≡N (III)
dans laquelle X₂ représente -(-CH₂-)ₘ-, 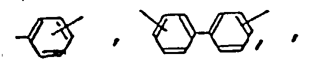 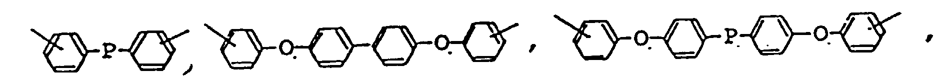 un groupe phénylène substitué, 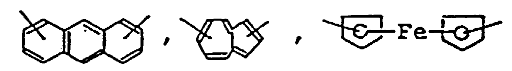 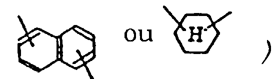 m étant un nombre entier de 1 à 12 et P représentant 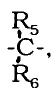 -O-, -CO-, -S- ou -SO₂-, R₅ et R₆ étant identiques ou différents et représentant chacun -H, -CH₃, -C₂H₅, -CF₃, 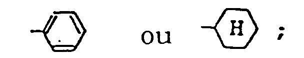 et Y₁ et Y₂ sont des restes organiques divalents identiques ou différents.

7. Composé de Schiff ayant un groupe cyanato à une extrémité de la molécule et étant représenté par la formule générale :
X₃-CH=N-Y₃-O-C≡N (III)
et/ou par la formule générale
X₃-N=CH-Y₃-O-C≡N (IV)
où X₃ représente -H-, alkyle en C₁-C₈, 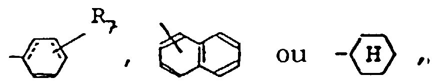 R₇ représentant -H, -F, -Cl, -Br, -CH₃, -CF₃, -OH, -NH₂, 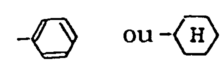 et Y₃ représente -(-CH₂-)ₘ-, 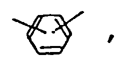 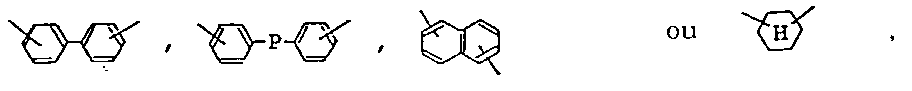 m étant un nombre entier de 1 à 12 et P représentant -(-CH₂-)ₘ-, -O-, -CO-, -S-, -SO₂-, 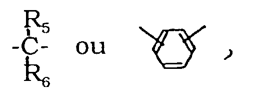 R₅ et R₆ étant identiques ou différents et représentent chacun -H, -CH₃, ^{-C}2^{H}5, ^{-CF}3,

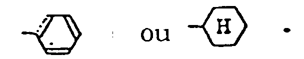

8. Revêtement de contrôle de l'orientation moléculaire pour un dispositif d'affichage à cristaux liquides, ledit revêtement étant un film organique formé sur un film électroconducteur transparent, dans lequel ledit film organique est constitué d'un polymère selon l'une quelconque des revendications 1 à 3.

9. Dispositif semiconducteur de type à résine scéllée obtenu en recouvrant au moins la surface du composant semiconducteur avec une résine durcie, la résine durcie étant constituée d'unités répétitives constituées essentiellement de cycles dihydrotriazines tels que définis dans l'une quelconque des revendications 1 à 3.

10. Utilisation des composés de Schiff tels que définis dans les revendications 1 à 3, ou de compositions contenant ces composés, en tant que composés de moulage.

11. Utilisation des composés de Schiff tels que définis dans les revendications 1 à 3, ou de compositions contenant ces composés, en tant que matériaux de laminage.

12. Utilisation des composés de Schiff tels que définis dans les revendications 1 à 3, ou de compositions contenant ces composés, en tant que peintures ou matériaux de revêtement.

13. Utilisation des composés de Schiff tels que définis dans les revendications 1 à 3, ou de compositions contenant ces composés, en tant qu'adhésifs.

14. Utilisation des composés de Schiff tels que définis dans les revendications 1 à 3, ou de compositions contenant ces composés, en tant que vernis.

15. Utilisation des composés de Schiff tels que définis dans les revendications 1 à 3, ou de compositions contenant ces composés, en tant que compositions d'encres et de toners.

16. Utilisation des composés de Schiff tels que définis dans les revendications 1 à 3, ou de compositions contenant ces composés, en tant que pâtes.

17. Utilisation des composés de Schiff tels que définis dans les revendications 1 à 3, ou de compositions contenant ces composés, en tant que compositions FRP.

18. Utilisation des composés de Schiff tels que définis dans les revendications 1 à 3, ou de compositions contenant ces composés, en tant que compositions de cristaux liquides.

19. Utilisation des composés de Schiff tels que définis dans les revendications 1 à 3, ou de compositions contenant ces composés, en tant que matériaux électroconducteurs.

20. Utilisation des composés de Schiff tels que définis dans les revendications 1 à 3, ou de compositions contenant ces composés, en tant que matériaux pour réacteurs nucléaires.

21. Utilisation des composés de Schiff tels que définis dans les revendications 1 à 3, ou de compositions contenant ces composés pour des résines de préimprégnation.

22. Utilisation des composés de Schiff tels que définis dans les revendications 1 à 3, ou de compositions contenant ces composés, en tant que films isolants interlaminaires.

23. Utilisation des composés de Schiff tels que définis dans les revendications 1 à 3, ou de compositions contenant ces composés, en tant que matériaux de revêtement pour la protection des surfaces de dispositifs LSI.

24. Utilisation des composés de Schiff tels que définis dans les revendications 1 à 3, ou de compositions contenant ces composés, en tant que films d'alignement pour des dispositifs à cristaux liquides.

25. Utilisation des composés de Schiff tels que définis dans les revendications 1 à 3, ou de compositions contenant ces composés, en tant qu'adhésifs en aéronautique ou dans l'industrie spatiale.

26. Utilisation des composés de Schiff tels que définis dans les revendications 1 à 3, ou de compositions contenant ces composés, en tant que pâtes à base d'argent.
